# EUROPÄISCHE PATENTSCHRIFT

(11) **EP 0 800 215 B1**
(45) Veröffentlichungstag und Bekanntmachung des Hinweises auf die Patenterteilung: **02.06.2004**
(21) Anmeldenummer: 97104415.1
(22) Anmeldetag: 14.03.1997
(51) Int. Cl.: H01L 29/78, H01L 29/49, H01L 21/8238

(54) **Integrierte Schaltungsstruktur mit mindestens einem MOS-Transistor und Verfahren zu deren Herstellung**
Integrated circuit structure with at least one MOS-transistor and method of fabrication thereof
Structure d'un circuit intégré avec au moins un transistor MOS et sa méthode de fabrication

(30) Priorität: 01.04.1996 DE 19612950
(43) Veröffentlichungstag der Anmeldung: 08.10.1997
(73) Patentinhaber: Infineon Technologies AG, 81669 München (DE)
(72) Erfinder: Schwalke, Udo, Dr., 84431 Heldenstein (DE)
(74) Vertreter: Kindermann, Peter

(56) Entgegenhaltungen:
- EP-A- 0 111 347
- EP-A- 0 798 785
- US-A- 5 418 392
- PATENT ABSTRACTS OF JAPAN vol. 016, no. 521 (E-1285), 27. Oktober 1992 -& JP 04 196437 A (NEC CORP), 16. Juli 1992
- PATENT ABSTRACTS OF JAPAN vol. 009, no. 169 (E-328), 13. Juli 1985 -& JP 60 043863 A (TOSHIBA KK), 8. März 1985

## Beschreibung

Für verschiedene technische Anwendungen, insbesondere für Low Voltage/Low Power-Anwendungen, werden MOS-Transistoren mit kurzer Kanallänge benötigt.

n⁺-dotiertes Silizium und p⁺-dotiertes Silizium unterscheiden sich in der Austrittsarbeit um 1,1 eV. Wegen dieser Austrittsarbeitsdifferenz kommt es in MOS-Transistoren mit einer Gateelektrode aus hochdotiertem Polysilizium zwischen der Gateelektrode und dem drainseitigen pn-Übergang zu einer Erhöhung der elektrischen Feldstärke, wenn sich der Leitfähigkeitstyp der Gateelektrode von dem Leitfähigkeitstyp der Source/Drain-Gebiete unterscheidet. Dieses gilt sowohl bei MOS-Transistoren mit n⁺-dotierter Gateelektrode und p⁺-dotierten Source/Drain-Gebieten als auch bei MOS-Transistoren mit p⁺-dotierter Gateelektrode und n⁺-dotierten Source/Drain-Gebieten. Diese Erhöhung der elektrischen Feldstärke führt zu einer Reduktion der Zuverlässigkeit des Gateoxids. Insbesondere bei MOS-Transistoren mit Kanallängen unter 0,25 µm, wie sie für Low Voltage/Low Power-Anwendungen mit Versorgungsspannungen unter 3 Volt eingesetzt werden und bei denen die Dicke des Gateoxids unter 5 nm liegt, wird die Felderhöhung problematisch, da die Austrittsarbeitsdifferenz konstant ist und nicht mit der Versorgungsspannung skaliert. Als Folge der Erhöhung der elektrischen Feldstärke tritt auch eine Verschlechterung des Leckstromverhaltens auf. Der gateinduzierte Drainleckstrom (Gate-Induced Drain Leakage GIDL) steigt an, weil wegen der erhöhten elektrischen Feldstärke die Band-zu-Band Tunnelwahrscheinlichkeit zunimmt.

In der erhöhten elektrischen Feldstärke zwischen Gateelektrode und drainseitigem pn-Übergang kann durch Verwendung eines anderen Materials für die Gateelektrode abgemildert oder gelöst werden, wobei dieses Material eine geringere oder gar keine Austrittsarbeitdifferenz zu dem Material des Source/Drain-Gebietes aufweist. Es ist vorgeschlagen worden, die Gateelektrode aus dotiertem Polysilizium, das von demselben Leitfähigkeitstyp wie die Source/Drain-Gebiete dotiert ist, zu bilden (siehe C. Parrillo, IEDM '85, p.398). Ferner ist vorgeschlagen worden, die Gateelektrode aus TiN (siehe zum Beispiel J. M. Hwang et al, IEDM '92, p345) oder Wolfram (siehe zum Beispiel N. Kasai et al, IEDM '88, p242) zu bilden. Mit der Verwendung von metallhaltigen Materialien als Gateelektrode direkt auf dem Gateoxid ist die Gefahr einer Gateoxidschädigung verbunden. Die Verwendung von dotiertem Polysilizium von demselben Leitfähigkeitstyp wie die Source/Drain-Gebiete für die Gateelektrode führt in CMOS-Schaltungen, die sowohl n-Kanal-Transistor als auch p-Kanal-Transistoren umfassen, zu einer aufwendigeren Prozeßführung, zum Bor-Penetrationeffekt, zur lateralen Dotierstoffdiffusion in durchgängigen n⁺-/ p⁺-Gateleitungen und zu einer Empfindlichkeit gegenüber dem Gatedepletioneffekt.

Schließlich ist vorgeschlagen worden, die Austrittsarbeit von n⁺- bzw. p⁺-dotiertem Polysilizium durch eine zusätzliche Dotierung mit Germanium zu modifizieren (siehe zum Beispiel T. J. King et al, IEDM '90, p253). Auch diese Maßnahme führt zu einer aufwendigen Prozeßführung, da einerseits spezielles Equipment benötigt wird und andererseits die Prozeßschritte den veränderten Materialeigenschaften, zum Beispiel beim Ätzen, angepaßt werden müssen.

In EP-A-0 657 929 ist vorgeschlagen worden, zur Verbesserung der Kurzkanaleffekte, des Leckstromverhaltens und der Zuverlässigkeit des Gateoxids bei p-Kanal-MOS-Transistoren mit n⁺-dotierter Gateelektrode durch eine zusätzliche Borimplantation die n⁺-dotierte Gateelektrode gegenzudotieren. Dabei wird die Austrittsarbeit der Gateelektrode verändert, ohne den Leitfähigkeitstyp der Gateelektrode zu verändern. Durch diese Maßnahme ändert sich die Dotierstoffkonzentration in der Gateelektrode. Damit steigt der Widerstand der Gateelektrode an, was zu einem Spannungsabfall an der Gateelektrode führt.

Jeder der Dokumente EP-A-0 111 347 und EP-A-0 798 785 offenbart eine integrierte Schaltungsstruktur mit mindestens einem MOS-FET und ein Verfahren zu deren Herstellung, in der die Dotierstoffkonzentration in der gesamten Gateelektrode nicht gleich ist.

Der Erfindung liegt das Problem zugrunde, eine Schaltungsstruktur mit mindestens einem MOS-Transistor anzugeben, bei der der MOS-Transistor eine verbesserte Gateoxidzuverlässigkeit und ein verbessertes Leckstromverhalten bei gleichzeitig geringem Widerstand der Gateelektrode aufweist. Ferner soll ein Verfahren zu deren Herstellung angegeben werden.

Dieses Problem wird erfindungsgemäß gelöst durch eine integrierte Schaltungsstruktur sowie ein Verfahren zu deren Herstellung nach den Ansprüchen.

Wird der MOS-Transistor gemäß der Erfindung eingeschaltet, so wird die Seitenfläche der Gateelektrode aufgrund der Potentialverhältnisse in Akkumulation getrieben. Damit bleiben die wesentlichen Transistoreigenschaften erhalten. Sperrt der MOS-Transistor dagegen, so bildet sich an der Seitenfläche der Gateelektrode wegen der geringeren Dotierstoffkonzentration eine Raumladungszone aus. Diese Raumladungszone bildet sich oberhalb des Source/Drain-Gebietes aus und reduziert hier die elektrische Feldstärke. Damit werden die mit der erhöhten elektrischen Feldstärke verbundenen Probleme vermieden. Vorzugsweise wird der MOS-Transistor im Betrieb so verschaltet, daß die Seitenfläche der Gateelektrode, der eine geringere Dotierstoffkonzentration aufweist, an das als Drain verschaltete Source/Drain-Gebiet angrenzt.

Da die Dotierstoffkonzentration in der Mitte der Gateelektrode höher ist als an der Seitenfläche, wird der Widerstand der Gateelektrode durch die Dotierstoffkonzentration in der Mitte der Gateelektrode bestimmt. Die erhöhte Dotierstoffkonzentration in der Mitte der Gateelektrode bewirkt einen geringeren Widerstand der Gateelektrode.

Es liegt im Rahmen der Erfindung, an mehr als einer Seitenfläche der Gateelektrode eine geringere Dotierstoffkonzentration vorzusehen. Insbesondere liegt es im Rahmen der Erfindung, die Gateelektrode mit rechteckigem Querschnitt vorzusehen und an den vier Seitenflächen des Rechtecks eine geringere Dotierstoffkonzentration zu realisieren.

Bei gleichzeitiger Herstellung des MOS-Transistors und eines dazu komplementären MOS-Transistors werden die Gateelektroden beider MOS-Transistoren durch Strukturierung der dotierten Siliziumschicht gebildet. Die Dotierstoffkonzentration an der Seitenfläche der Gateelektrode des erstgenannten MOS-Transistors wird durch eine Gegendotierung reduziert. Die Dotierstoffkonzentration der Gateelektrode des komplementären MOS-Transistors wird durch eine zusätzliche Dotierung über die gesamte Gateelektrode erhöht.

Die erfindungsgemäße Schaltungsstruktur ist sowohl für Low Voltage/ Low Power-Anwendungen als auch für Hochvolttransistoren, insbesondere in Smart-Power-Technologien oder für Flash-EPROM geeignet.

Im folgenden wird die Erfindung anhand eines Ausführungsbeispiels und der Figuren näher erläutert.
- Figur 1: zeigt ein Substrat mit unterschiedlich dotierten Wannen, Feldoxidbereichen, eine dieelektrischen Schicht, eine dotierte Siliziumschicht und eine Deckschicht.
- Figur 2: zeigt das Substrat nach Bildung von Gateelektroden, Flankenbedeckungen an den Gateelektroden und Streuoxidschichten an der Oberfläche der Wannen.
- Figur 3: zeigt das Substrat nach Bildung einer Maske und Erzeugung von p-dotierten Source/Drain-Gebieten.
- Figur 4: zeigt das Substrat nach einer geneigten Implantation zur Reduktion der Dotierstoffkonzentration am Rand der Gateelektrode und zur Bildung eines Anschlußgebietes.
- Figur 5: zeigt das Substrat nach Bildung einer weiteren Maske und nach Bildung von n-dotierten Source/Drain-Gebieten.
- Figur 6: zeigt das Substrat nach einem Temperschritt zur Aktivierung der Dotierstoffe und nach Silizierung der Oberfläche der Source/Drain-Gebiete und der Gateelektroden.
- Figur 7: zeigt den in Figur 6 mit VII-VII bezeichneten Schnitt.

Die Darstellungen in den Figuren sind nicht maßstäblich.

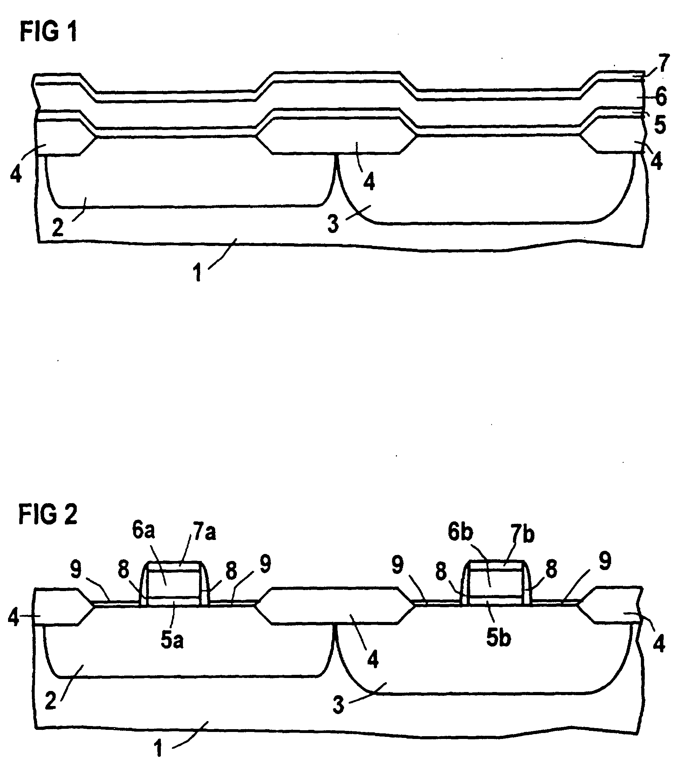

In einem Substrat 1 aus zum Beispiel n-dotiertem oder p-dotiertem monokristallinem Silizium mit einer Grunddotierung von 10¹⁵ cm⁻³ werden zunächst in bekannter Weise eine n-dotierte Wanne 2 und eine p-dotierte Wanne 3 gebildet. Es werden zum Beispiel in einem LOCOS-Prozeß Feldoxidgebiete 4 erzeugt, die in der n-dotierten Wanne ein aktives Gebiet für einen PMOS-Transistor und in der p-dotierten Wanne 3 ein aktives Gebiet für einen NMOS-Transistor definieren (siehe Figur 1). In der p-dotierten Wanne 2 wird eine Dotierstoffkonzentration von zum Beispiel 10¹⁷ cm⁻³ Bor, in der n-dotierten Wanne 3 eine Dotierstoffkonzentration von zum Beispiel 10¹⁷ cm⁻³ Phosphor eingestellt.

Es wird ganzflächig eine dielektrische Schicht 5 zum Beispiel durch thermische Oxidation aus SiO₂ in einer Schichtdicke von 3 bis 10 nm aufgewachsen. Auf die dielektrische Schicht 5 wird eine dotierte Siliziumschicht 6 aus zum Beispiel in situ dotiertem n-dotiertem Polysilizium oder in situ dotiertem, n-dotiertem amorphem Silizium erzeugt. Als Dotierstoff wird Arsen oder Phosphor verwendet. Die Dotierstoffkonzentration liegt unter 1 x 10²⁰ Atome/cm³, vorzugsweise bei 5x10¹⁹ Atome/cm³. Bei dieser Dotierstoffkonzentration ist das Silizium gerade noch degeneriert dotiert. Die dotierte Siliziumschicht 6 kann alternativ durch Abscheidung von undotiertem amorphem oder polykristallinem Silizium und anschließender Dotierung zum Beispiel durch Belegung oder Implantation gebildet werden. In situ dotiertes Silizium wird jedoch wegen der gleichmäßigeren Dotierstoffverteilung und Aktivierung für die dotierte Siliziumschicht 6 bevorzugt.

Auf die dotierte Siliziumschicht 6 wird ganzflächig eine Deckschicht 7 aus zum Beispiel Si₃N₄ oder durch CVD abgeschiedenem SiO₂ aufgebracht. Die dotierte Siliziumschicht 6 wird in einer Schichtdicke von zum Beispiel 100 bis 500 nm gebildet. Die Deckschicht wird in einer Schichtdicke von zum Beispiel 100 - 200 nm CVD - SiO₂ gebildet.

Unter Verwendung photolithographischer Prozeßschritte wird anschließend eine Maske (nicht dargestellt) gebildet, mit deren Hilfe die Deckschicht 7, die dotierte Siliziumschicht 6 und die dielektrische Schicht 5 in einem anisotropen Ätzschritt zum Beispiel mit HBr/ Cl₂ strukturiert werden. Dabei entstehen für den PMOS-Transistor ein Gatedielektrikum 5a, eine Gateelektrode 6a und eine Abdeckung 7a. Für den NMOS-Transistor entstehen ein Gatedielektrikum 5b, eine Gateelektrode 6b und eine Abdeckung 7b (siehe Figur 2). Die Flanken von Abdeckung 7a bzw. 7b, Gateelektrode 6a bzw. 6b und Gatedielektrikum 5a bzw. 5b werden anschließend mit SiO₂-Spacern 8 versehen. Dazu wird ganzflächig eine SiO₂-Schicht mit konformer Kantenbedeckung abgeschieden und durch anisotropes Rückätzen strukturiert.

Die freiliegenden Oberflächen der p-dotierten Wanne 2 und der n-dotierten Wanne 3 werden thermisch reoxidiert. Dabei bildet sich ein Streuoxid 9 in einer Schichtdicke von zum Beispiel 10 nm.

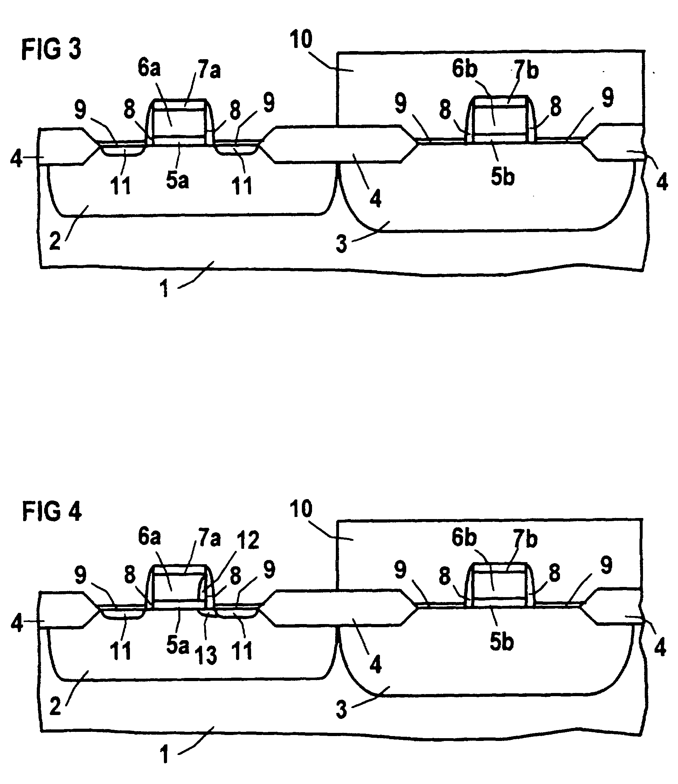

Es wird eine erste Photolackmaske 10 gebildet, die den aktiven Bereich für den NMOS-Transistor abdeckt. Anschließend wird eine Implantation mit Bor oder BF₂ durchgeführt, bei der p⁺-dotierte Gebiete 11 für den PMOS-Transistor gebildet werden. Die Implantation erfolgt zum Beispiel mit 5 x 10¹⁵ B/cm³ und einer Energie von 10 keV. Die Abdeckung 7a schützt die Gateelektrode 6a vor den implantierenden Ionen. Dazu ist für die Abdeckung 7a eine Schichtdicke von mindestens 100 nm SiO₂ oder von 80 nm Si₃N₄ erforderlich (siehe Figur 3). Die Implantation erfolgt im wesentlichen senkrecht auf die Oberfläche des Substrats 1.

Anschließend wird eine weitere Implantation mit Bor durchgeführt, bei der die Richtung der Implantation geneigt wird. Vorzugsweise erfolgt die Implantation unter einem Winkel von 10 - 30° gegen die Normale der Substratoberfläche. Dabei wird an einer Seitenfläche der Gateelektrode 6a ein geringer dotiertes Gebiet 12 gebildet. Die Dotierstoffkonzentration in dem geringer dotierten Gebiet 12 stellt sich durch Gegendotierung der Borionen mit den n-dotierenden Ionen der dotierten Siliziumschicht 6 ein. Die Nettodotierstoffkonzentration in dem geringer dotierten Gebiet 12 wird vorzugsweise auf 10¹⁸ cm⁻³ eingestellt. Bei der geneigten Implantation entsteht gleichzeitig ein flaches Anschlußgebiet 13, das an eines der p⁺-dotierten Gebiete 11 angrenzt (siehe Figur 4).

Die geneigte Implantation kann viermal an dem jeweils unter 90 ° gedrehten Substrat 1 durchgeführt werden, um eine Symmetrische Anordnung zu erhalten (nicht dargestellt).

Nach Entfernen der ersten Photolackmaske 10 wird die Abdekkung 7a, 7b bei Si₃N₄ mit zum Beispiel H₃PO₄ entfernt. Die freiliegende Oberfläche der Gateelektroden 6a, 6b wird mit einem Streuoxid 14 versehen. Das Streuoxid 14 wird zum Beispiel durch thermische Oxidation in einer Schichtdicke von 10 nm gebildet.

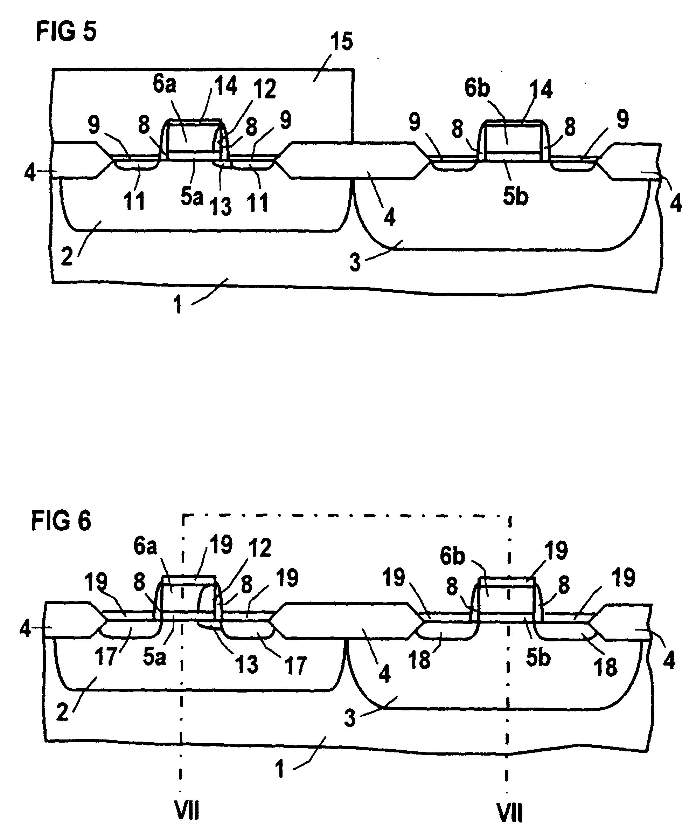

Anschließend wird eine zweite Photolackmaske 15 gebildet, die den aktiven Bereich für den PMOS-Transistor abdeckt. Der aktive Bereich für den NMOS-Transistor liegt dagegen frei. Es wird eine Arsen- oder Phosophorimplantation durchgeführt, bei der n⁺-dotierte Gebiete 16 hergestellt werden. Gleichzeitig wird die Dotierstoffkonzentration in der Gateelektrode 6b vergrößert. Die Implantation erfolgt zum Beispiel mit 5 x 10¹⁵ As/cm³ bei 80 keV (siehe Figur 5).

Nach Entfernen der zweiten Photolackmaske 15 wird das Substrat 1 getempert. Dabei wird der Dotierstoff elektrisch aktiviert. Dabei bilden sich aus den p⁺-dotierten Gebieten 11 p⁺-dotierte Source/Drain-Gebiete 17 und aus den n⁺-dotierten Gebieten 16 n⁺-dotierte Source/Drain-Gebiete 18. Die Ausdehnung des geringer dotierten Gebietes 12 sowie des Anschlußgebietes 13 vergrößert sich ebenfalls (siehe Figur 6).

Anschließend wird das Streuoxid 9, 14 zum Beispiel durch einen kurzen HF- Dip entfernt. Die dabei freigelegten Siliziumflächen der p⁺-dotierten Source/Drain-Gebiete 17, der n⁺-dotierten Source/Drain-Gebiete 18 sowie der Gateelektroden 6a, 6b werden anschließend mit einem metallischen Leiter 19 zur Verbesserung des Anschlußwiderstands versehen. Der metallische Leiter 19 wird zum Beispiel durch eine selbstjustierte Silizierungsreaktion mit TiSi₂ oder durch selektive Abscheidung von Metall, zum Beispiel CVD-Wolfram, gebildet. Neben der Erhöhung der Leitfähigkeit der Gateelektroden 6a, 6b überbrückt der metallische Leiter 19 aneinandergrenzende n⁺-dotierte Bereiche und n-dotierte Bereiche der Gateelektroden 6a, 6b.

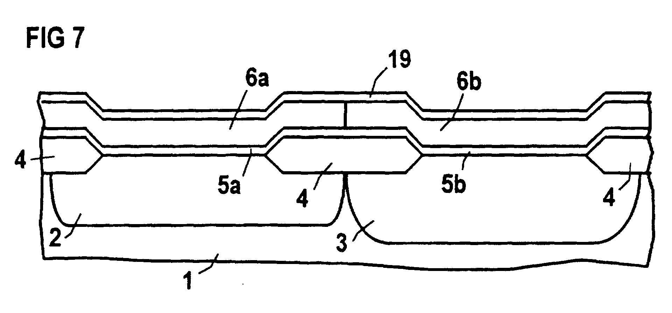

Figur 7 stellt den in Figur 6 mit VII-VII bezeichneten Schnitt durch die Struktur dar. Außerhalb der in Figur 6 dargestellten Zeichenebene verlaufen die Gateelektroden 6a, 6b oberhalb der Feldoxidbereiche 4 und sind dort miteinander verbunden. Der metallische Leiter 19 stellt eine homogene Leitfähigkeit in diesem Verbindungsbereich sicher (siehe Figur 7).

Zur Fertigstellung der Schaltungsstruktur wird zum Beispiel durch eine BPSG-Abscheidung und anschließende Planarisierung eine Passivierungsschicht aufgebracht, in der Kontaktlöcher geätzt und metallisiert werden. Diese Prozeßschritte sind nicht im einzelnen dargestellt.

Das Verfahren kann auch für CMOS-Schaltungen mit p-dotierter Gateelektrode angewendet werden. In diesem Fall wird die Gateelektrode des n-Kanal-MOS-Transistors am Rand mit einem geringer dotierten Gebiet versehen. Die Gateelektrode des p-Kanal-MOS-Transistors wird dagegen durch eine zusätzliche Implantation höher dotiert.

## Patentansprüche (Patentansprüche für folgende(n) Vertragsstaat(en): DE, FR, GB, IT)

1. Schaltungsstruktur mit mindestens einem MOS-Transistor,
- bei der in einem Halbleitersubstrat (1) zwei Source/Drain-Gebiete (17) vorgesehen sind, die von einem ersten Leitfähigkeitstyp dotiert sind,
- bei der zwischen den Source/Drain-Gebieten (17) ein Kanalbereich angeordnet ist, an dessen Oberfläche ein Gatedielektrikum (5a) und eine Gateelektrode (6a) angeordnet sind,
- bei der die gesamte Gateelektrode (6a) von einem zweiten, dem ersten entgegengesetzten Leitfähigkeitstyp dotiertes Silizium umfaßt,
- bei der die Dotierstoffkonzentration in der Gateelektrode (6a) mindestens in einem Gebiet (12) an einer Seitenfläche der Gateelektrode geringer ist als in der Mitte der Gateelektrode (6a),
- wobei die Dotierstoffkonzentration in dem Gebiet (12) an der Seitenfläche der Gateelektrode (12) im Bereich zwischen 10¹⁷ und 10¹⁹ cm⁻³ liegt
- und/oder dass ein weiterer, zu dem erstgenannten MOS-Transistor komplementärer MOS-Transistor vorgesehen ist,
- wobei der komplementäre MOS-Transistor vom zweiten Leitfähigkeitstyp dotierte Source/Drain-Gebiete (18) und eine Gateelektrode (6b), die vom zweiten Leitfähigkeitstyp dotiertes Silizium in über die gesamte Gateelektrode gleichbleibender Dotierstoffkonzentration umfaßt, aufweist.

2. Verfahren zur Herstellung einer Schaltungsstruktur mit mindestens einem MOS-Transistor,
- bei dem in einem Halbleitersubstrat (1) zwei Source/Drain-Gebiete (17), die von einem ersten Leitfähigkeitstyp dotiert sind, und ein dazwischen angeordneter Kanalbereich erzeugt werden,
- bei dem an der Oberfläche des Kanalbereichs ein Gatedielektrikum (5a) und eine Gateelektrode (6a) gebildet werden,
- bei dem die gesamte Gateelektrode aus von einem zweiten, dem ersten entgegengesetzten Leitfähigkeitstyp dotierten Silizium gebildet wird, wobei die Dotierstoffkonzentration in mindestens einem Gebiet (12) an einer Seitenfläche der Gateelektrode geringer ist als in der Mitte der Gateelektrode (6a).
- und bei dem zur Bildung der Gateelektrode (6a) eine dotierte Siliziumschicht, die eine Dotierstoffkonzentration wie in der Mitte der Gateelektrode (6a) aufweist, abgeschieden und strukturiert wird,
- wobei in dem Gebiet (12) an der Seitenfläche der Gateelektrode (6a) die Dotierstoffkonzentration durch eine geeignete Implantation mit vom ersten Leitfähigkeitstyp dotierenden Ionen abgesenkt wird, so dass die Dotierstoffkonzentration in dem Gebiet (12) an der Seitenfläche der Gateelektrode im Bereich zwischen 10¹⁷ und 10¹⁹ cm⁻³ liegt.

3. Verfahren nach Anspruch 2,
- bei dem auf die dotierte Siliziumschicht (6) eine Deckschicht (7) aufgebracht wird, die gemeinsam mit der Siliziumschicht (6) strukturiert wird,
- bei dem die Flanken der Gateelektrode (6a) mit isolierenden Spacern (8) versehen werden,
- bei dem die Source/Drain-Gebiete (17) selbstjustiert zur Gateelektrode (6a) gebildet werden.

4. Verfahren nach Anspruch 2 oder 3,
bei dem in dem Halbleitersubstrat (1) ein zu dem erstgenannten MOS-Transistor komplementärer MOS-Transistor gebildet wird, der vom zweiten Leitfähigkeitstyp dotierte Source/Drain-Gebiete (18) aufweist und eine vom zweiten Leitfähigkeitstyp dotierte Gateelektrode (6b) aufweist.

5. Verfahren nach Anspruch 3 oder 4,
- bei dem bei der Strukturierung der Siliziumschicht (6) auch die Gateelektrode (6b) für den komplementären MOS-Transistor gebildet wird,
- bei dem das Gebiet des komplementären MOS-Transistors während der Bildung der Source/Drain-Gebiete (17) des erstgenannten MOS-Transistors durch eine Maske (10) abgedeckt wird, die anschließend wieder entfernt wird,
- bei dem das Gebiet des erstgenannten MOS-Transistors mit einer weiteren Maske (15) abgedeckt wird,
- bei dem die Deckschicht von der Gateelektrode (6b) für den komplementären MOS-Transistor entfernt wird,
- bei dem eine Implantation mit vom zweiten Leitfähigkeitstyp dotierenden Ionen durchgeführt wird, bei der die Source/Drain-Gebiete des komplementären MOS-Transistors (18) gebildet werden und bei der die Dotierstoffkonzentration in der Gateelektrode (6b) des komplementären MOS-Transistors erhöht wird.

## Patentansprüche (Patentansprüche für folgende(n) Vertragsstaat(en): NL)

1. Schaltungsstruktur mit mindestens einem MOS-Transistor,
- bei der in einem Halbleitersubstrat (1) zwei Source/Drain-Gebiete (17) vorgesehen sind, die von einem ersten Leitfähigkeitstyp dotiert sind,
- bei der zwischen den Source/Drain-Gebieten (17) ein Kanalbereich angeordnet ist, an dessen Oberfläche ein Gatedielektrikum (5a) und eine Gateelektrode (6a) angeordnet sind,
- und bei der die gesamte Gateelektrode (6a) von einem zweiten, dem ersten entgegengesetzten Leitfähigkeitstyp dotiertes Silizium umfaßt,
- **dadurch gekennzeichnet, dass** die Dotierstoffkonzentration in der Gateelektrode (6a) mindestens in einem Gebiet (12) an einer Seitenfläche der Gateelektrode geringer ist als in der Mitte der Gateelektrode (6a).

2. Schaltungsstruktur nach Anspruch 1,
bei der die Dotierstoffkonzentration in dem Gebiet (12) an der Seitenfläche der Gateelektrode (12) im Bereich zwischen 10¹⁷ und 10¹⁹ cm⁻³ liegt.

3. Schaltungsstruktur nach Anspruch 1 oder 2,
- bei der ein weiterer, zu dem erstgenannten MOS-Transistor komplementärer MOS-Transistor vorgesehen ist,
- bei der der komplementäre MOS-Transistor vom zweiten Leitfähigkeitstyp dotierte Source/Drain-Gebiete (18) und eine Gateelektrode (6b), die vom zweiten Leitfähigkeitstyp dotiertes Silizium umfaßt, aufweist.

4. Verfahren zur Herstellung einer Schaltungsstruktur mit mindestens einem MOS-Transistor,
- bei dem in einem Halbleitersubstrat (1) zwei Source/Drain-Gebiete (17), die von einem ersten Leitfähigkeitstyp dotiert sind, und ein dazwischen angeordneter Kanalbereich erzeugt werden,
- bei dem an der Oberfläche des Kanalbereichs ein Gatedielektrikum (5a) und eine Gateelektrode (6a) gebildet werden,
- wobei die gesamte Gateelektrode aus von einem zweiten, dem ersten entgegengesetzten Leitfähigkeitstyp dotierten Silizium gebildet wird, **dadurch gekennzeichnet, dass** die Dotierstoffkonzentration mindestens in einem Gebiet (12) an einer Seitenfläche der Gateelektrode geringer ist als in der Mitte der Gateelektrode (6a).

5. Verfahren nach Anspruch 4,
- bei dem zur Bildung der Gateelektrode (6a) eine dotierte Siliziumschicht, die eine Dotierstoffkonzentration wie in der Mitte der Gateelektrode (6a) aufweist, abgeschieden und strukturiert wird,
- bei dem in dem Gebiet (12) an der Seitenfläche der Gateelektrode (6a) die Dotierstoffkonzentration durch eine geeignete Implantation mit vom ersten Leitfähigkeitstyp dotierenden Ionen abgesenkt wird.

6. Verfahren nach Anspruch 5,
- bei dem auf die dotierte Siliziumschicht (6) eine Deckschicht (7) aufgebracht wird, die gemeinsam mit der Siliziumschicht (6) strukturiert wird,
- bei dem die Flanken der Gateelektrode (6a) mit isolierenden Spacern (8) versehen werden,
- bei dem die Source/Drain-Gebiete (17) selbstjustiert zur Gateelektrode (6a) gebildet werden.

7. Verfahren nach einem der Ansprüche 4 bis 6, bei dem in dem Halbleitersubstrat (1) ein zu dem erstgenannten MOS-Transistor komplementärer MOS-Transistor gebildet wird, der vom zweiten Leitfähigkeitstyp dotierte Source/Drain-Gebiete (18) aufweist und eine vom zweiten Leitfähigkeitstyp dotierte Gateelektrode (6b) aufweist.

8. Verfahren nach Anspruch 6 und 7,
- bei dem bei der Strukturierung der Siliziumschicht (6) auch die Gateelektrode (6b) für den komplementären MOS-Transistor gebildet wird,
- bei dem das Gebiet des komplementären MOS-Transistors während der Bildung der Source/Drain-Gebiete (17) des erstgenannten MOS-Transistors durch eine Maske (10) abgedeckt wird, die anschließend wieder entfernt wird,
- bei dem das Gebiet des erstgenannten MOS-Transistors mit einer weiteren Maske (15) abgedeckt wird,
- bei dem die Deckschicht von der Gateelektrode (6b) für den komplementären MOS-Transistor entfernt wird,
- bei dem eine Implantation mit vom zweiten Leitfähigkeitstyp dotierenden Ionen durchgeführt wird, bei der die Source/Drain-Gebiete des komplementären MOS-Transistors (18) gebildet werden und bei der die Dotierstoffkonzentration in der Gateelektrode (6b) des komplementären MOS-Transistors erhöht wird.

## Claims (Claims for the following Contracting State(s): DE, FR, GB, IT)

1. Circuit structure having at least one MOS transistor,
- in which two source/drain regions (17) which are doped by a first conductivity type are provided in a semiconductor substrate (1),
- in which a channel region, on whose surface a gate dielectric (5a) and a gate electrode (6a) are arranged, is arranged between the source/drain regions (17),
- in which the entire gate electrode (6a) comprises silicon which is doped by a second conductivity type opposite to the first,
- in which the dopant concentration in the gate electrode (6a) is lower at least in one region (12) at a side area of the gate electrode than in the centre of the gate electrode (6a),
- the dopant concentration in the region (12) at the side area of the gate electrode (12) lying in the range between 10¹⁷ and 10¹⁹ cm⁻³,
- and/or a further MOS transistor which is complementary to the first-mentioned MOS transistor being provided,
- the complementary MOS transistor having source/drain regions (18), which are doped by the second conductivity type, and a gate electrode (6b), which comprises silicon which is doped by the second conductivity type in a dopant concentration which is constant over the entire gate electrode.

2. Method for producing a circuit structure having at least one MOS transistor,
- in which two source/drain regions (17), which are doped by a first conductivity type, and a channel region (inbetween) are produced in a semiconductor substrate (1),
- in which a gate dielectric (5a) and a gate electrode (6a) are formed on the surface of the channel region,
- in which the entire gate electrode is formed from silicon which is doped by a second conductivity type opposite to the first, the dopant concentration being lower in at least one region (12) at a side area of the gate electrode than in the centre of the gate electrode (6a).
- and in which, in order to form the gate electrode (6a), a doped silicon layer having a dopant concentration like that in the centre of the gate electrode (6a) is deposited and structured,
- the dopant concentration being reduced in the region (12) at the side area of the gate electrode (6a) by means of suitable implantation with doping ions of the first conductivity type, so that the dopant concentration in the region (12) at the side area of the gate electrode lies in the range between 10¹⁷ and 10¹⁹ cm⁻³.

3. Method according to Claim 2,
- in which a covering layer (7) is applied to the doped silicon layer (6) and is structured together with the silicon layer (6),
- in which the flanks of the gate electrode (6a) are provided with insulating spacers (8),
- in which the source/drain regions (17) are formed in a self-aligned manner with respect to the gate electrode (6a).

4. Method according to Claim 2 or 3,
in which a MOS transistor which is complementary to the first-mentioned MOS transistor, has source/drain regions (18) which are doped by the second conductivity type and has a gate electrode (6b) which is doped by the second conductivity type is formed in the semiconductor substrate (1).

5. Method according to Claim 3 or 4,
- in which the gate electrode (6b) for the complementary MOS transistor is also formed during the structuring of the silicon layer (6),
- in which the region of the complementary MOS transistor is covered by a mask (10) during the formation of the source/drain regions (17) of the first-mentioned MOS transistor, which mask is subsequently removed again,
- in which the region of the first-mentioned MOS transistor is covered with a further mask (15),
- in which the covering layer is removed from the gate electrode (6b) for the complementary MOS transistor,
- in which implantation with doping ions of the second conductivity type is carried out, during which the source/drain regions of the complementary MOS transistor (18) are formed and during which the dopant concentration in the gate electrode (6b) of the complementary MOS transistor is increased.

## Claims (Claims for the following Contracting State(s): NL)

1. Circuit structure having at least one MOS transistor,
- in which two source/drain regions (17) which are doped by a first conductivity type are provided in a semiconductor substrate (1),
- in which a channel region, on whose surface a gate dielectric (5a) and a gate electrode (6a) are arranged, is arranged between the source/drain regions (17),
- in which the entire gate electrode (6a) comprises silicon which is doped by a second conductivity type opposite to the first,
- **characterized in that** the dopant concentration in the gate electrode (6a) is lower at least in one region (12) at a side area of the gate electrode than in the centre of the gate electrode (6a).

2. Circuit structure according to Claim 1,
in which the dopant concentration in the region (12) at the side area of the gate electrode (12) lies in the range between 10¹⁷ and 10¹⁹ cm⁻³.

3. Circuit structure according to Claim 1 or 2,
in which a further MOS transistor which is complementary to the first-mentioned MOS transistor is provided,
- in which the complementary MOS transistor has source/drain regions (18), which are doped by the second conductivity type, and a gate electrode (6b), which comprises silicon which is doped by the second conductivity type.

4. Method for producing a circuit structure having at least one MOS transistor,
- in which two source/drain regions (17), which are doped by a first conductivity type, and a channel region (inbetween) are produced in a semiconductor substrate (1),
- in which a gate dielectric (5a) and a gate electrode (6a) are formed on the surface of the channel region,
- the entire gate electrode being formed from silicon which is doped by a second conductivity type opposite to the first,
- **characterized in that** the dopant concentration is lower at least in one region (12) at a side area of the gate electrode than in the centre of the gate electrode (6a).

5. Method according to Claim 4, in which, in order to form the gate electrode (6a), a doped silicon layer having a dopant concentration like that in the centre of the gate electrode (6a) is deposited and structured,
- in which the dopant concentration is reduced in the region (12) at the side area of the gate electrode (6a) by means of suitable implantation with doping ions of the first conductivity type.

6. Method according to Claim 5,
- in which a covering layer (7) is applied to the doped silicon layer (6) and is structured together with the silicon layer (6),
- in which the flanks of the gate electrode (6a) are provided with insulating spacers (8),
- in which the source/drain regions (17) are formed in a self-aligned manner with respect to the gate electrode (6a).

7. Method according to one of Claims 4 to 6,
in which a MOS transistor which is complementary to the first-mentioned MOS transistor, has source/drain regions (18) which are doped by the second conductivity type and has a gate electrode (6b) which is doped by the second conductivity type is formed in the semiconductor substrate (1).

8. Method according to Claims 6 and 7,
- in which the gate electrode (6b) for the complementary MOS transistor is also formed during the structuring of the silicon layer (6),
- in which the region of the complementary MOS transistor is covered by a mask (10) during the formation of the source/drain regions (17) of the first-mentioned MOS transistor, which mask is subsequently removed again,
- in which the region of the first-mentioned MOS transistor is covered with a further mask (15),
- in which the covering layer is removed from the gate electrode (6b) for the complementary MOS transistor,
- in which implantation with doping ions of the second conductivity type is carried out, during which the source/drain regions of the complementary MOS transistor (18) are formed and during which the dopant concentration in the gate electrode (6b) of the complementary MOS transistor is increased.

## Revendications (Revendications pour l'(les) Etat(s) contractant(s) suivant(s): DE, FR, GB, IT)

1. Structure de circuit ayant au moins un transistor MOS,
- dans lequel il est prévu, dans un substrat (1) semi-conducteur, deux zones (17) de source/drain, qui sont dopées par un premier type de conductivité,
- dans lequel il est disposé, entre les zones (17) de source/drain, une région de canal à la surface de laquelle est disposé un diélectrique (5a) de grille et une électrode (6a) de grille,
- dans laquelle toute l'électrode (6a) de grille comprend du silicium dopé par un deuxième type de conductivité opposé au premier,
- dans laquelle la concentration de substance de dopage de l'électrode (6a) de grille est, au moins dans une zone (12) sur une surface latérale de l'électrode de grille, plus petite qu'au milieu de l'électrode (6a) de grille,
- la concentration de substance de dopage dans une zone (12) sur la surface latérale de l'électrode (12) de grille est comprise entre 10¹⁷ et 10¹⁹ cm⁻³,
- et/ou en ce qu'il est prévu un autre transistor MOS complémentaire du transistor MOS mentionné en premier,
- le transistor MOS complémentaire ayant des zones (18) de source/drain dopées par le deuxième type de conductivité et une électrode (6b) de grille, qui comprend du silicium dopé par le deuxième type de conductivité en une concentration de la substance de dopage restant la même sur toute l'électrode de grille.

2. Procédé de production d'une structure de circuit ayant au moins un transistor MOS,
- dans lequel on produit, dans un substrat (1) semi-conducteur, deux zones (17) de source/drain qui sont dopées par un premier type de conductivité, et une région de canal disposée entre elles,
- dans lequel on forme, à la surface de la région de canal, un diélectrique (5a) de grille et une électrode (6a) de grille,
- dans lequel on forme toute l'électrode de grille en du silicium dopé par un deuxième type de conductivité opposé au premier, la concentration de la substance de dopage dans au moins une zone (12) d'une surface latérale de l'électrode de grille étant plus petite qu'au milieu de l'électrode (6a) de grille,
- et dans lequel, pour la formation de l'électrode (6a) de grille, on dépose et on structure une couche de silicium dopé qui a une concentration de substance de dopage comme au milieu de l'électrode (6a) de grille,
- dans lequel on incorpore, dans la zone (12) de la surface latérale de l'électrode (6a) de grille la concentration de la substance de dopage par une implantation appropriée par des ions dopants du premier type de conductivité, de sorte que la concentration de la substance de dopage dans la zone (12) sur la surface latérale de l'électrode de grille soit comprise entre 10¹⁷ et 10¹⁹ cm⁻³.

3. Procédé suivant la revendication 2,
- dans lequel on dépose sur la couche (6) de silicium dopé une couche (7) de finition qui est structurée conjointement avec la couche (6) de silicium,
- dans lequel on munit les flancs de l'électrode (6a) de grille d'espaceurs (8) isolants,
- dans lequel on forme les zones (17) de source/drain de manière auto-alignée par rapport à l'électrode (6a) de grille.

4. Procédé suivant la revendication 2 ou 3,
- dans lequel on forme dans le substrat (1) semi-conducteur un transistor MOS complémentaire du transistor MOS mentionné en premier qui a des zones (18) de source/drain dopées par le deuxième type de conductivité et une électrode (6b) de grille dopée par le deuxième type de conductivité.

5. Procédé suivant la revendication 3 ou 4,
- dans lequel on forme, lors de la structuration de la couche (6) de silicium, également l'électrode (6b) de grille du transistor MOS complémentaire,
- dans lequel on recouvre la région du transistor MOS complémentaire, pendant la formation des zones (17) de source/drain du transistor MOS mentionné en premier, d'un masque (10) que l'on élimine ensuite à nouveau,
- dans lequel on recouvre la région du transistor MOS mentionné en premier d'un autre masque (15),
- dans lequel on élimine la couche de finition de l'électrode (6b) de grille du transistor MOS complémentaire,
- dans lequel on effectue une implantation par des ions dopés par le deuxième type de conductivité, dans lequel on forme les zones de source/drain du transistor (18) MOS complémentaire et dans lequel on augmente la concentration de la substance de dopage dans l'électrode (6b) de grille du transistor MOS complémentaire.

## Revendications (Revendications pour l'(les) Etat(s) contractant(s) suivant(s): NL)

1. Structure de circuit ayant au moins un transistor MOS,
- dans lequel il est prévu, dans un substrat (1) semi-conducteur, deux zones (17) de source/drain, qui sont dopées par un premier type de conductivité,
- dans lequel il est disposé, entre les zones (17) de source/drain, une région de canal à la surface de laquelle est disposé un diélectrique (5a) de grille et une électrode(6a) de grille,
- dans laquelle toute l'électrode (6a) de grille comprend du silicium dopé par un deuxième type de conductivité opposé au premier,
**caractérisé en ce que** la concentration de dopage de l'électrode (6a) de grille est, au moins dans une zone (12) sur une surface latérale de l'électrode de grille, plus petite qu'au milieu de l'électrode (6a) de grille,

2. Structure suivant la revendication 1,
- dans laquelle la concentration de substance de dopage dans une zone (12) sur la surface latérale de l'électrode (12) de grille est comprise entre 10¹⁷ et 10¹⁹ cm⁻³.

3. Structure suivant la revendication 1 ou 2,
- dans laquelle il est prévu un autre transistor MOS complémentaire du transistor MOS mentionné en premier,
- le transistor MOS complémentaire ayant des zones (18) de source/drain dopées par le deuxième type de conductivité et une électrode (6b) de grille, qui comprend du silicium dopé par le deuxième type de conductivité.

4. Procédé de production d'une structure de circuit ayant au moins un transistor MOS,
- dans lequel on produit, dans un substrat (1) semi-conducteur, deux zones (17) de source/drain qui sont dopées par un premier type de conductivité, et une région de canal disposée entre elles,
- dans lequel on forme, à la surface de la région de canal, un diélectrique (5a) de grille et une électrode (6a) de grille,
**caractérisé en ce qu'**on forme toute l'électrode de grille en du silicium dopé par un deuxième type de conductivité opposé au premier, la concentration de la substance de dopage dans au moins une zone (12) d'une surface latérale de l'électrode de grille étant plus petite qu'au milieu de l'électrode (6a) de grille.

5. Procédé suivant la revendication 4,
- dans lequel, pour la formation de l'électrode (6a) de grille, on dépose et on structure une couche de silicium dopé qui a une concentration de substance de dopage comme au milieu de l'électrode (6a) de grille,
- dans lequel on incorpore, dans la zone (12) de la surface latérale de l'électrode (6a) de grille la concentration de la substance de dopage par une implantation appropriée par des ions dopants du premier type de conductivité.

6. Procédé suivant la revendication 5,
- dans lequel on dépose sur la couche (6) de silicium dopé une couche (7) de finition qui est structurée conjointement avec la couche (6) de silicium,
- dans lequel on munit les flancs de l'électrode (6a) de grille d'espaceurs (8) isolants,
- dans lequel on forme les zones (17) de source/drain de manière auto-alignée par rapport à l'électrode (6a) de grille.

7. Procédé suivant l'une des revendications 4 à 6,
- dans lequel on forme dans le substrat (1) semi-conducteur un transistor MOS complémentaire du transistor MOS mentionné en premier qui a des zones (18) de source/drain dopées par le deuxième type de conductivité et une électrode (6b) de grille dopée par le deuxième type de conductivité.

8. Procédé suivant la revendication 6 ou 7,
- dans lequel on forme, lors de la structuration de la couche (6) de silicium, également l'électrode (6b) de grille du transistor MOS complémentaire,
- dans lequel on recouvre la région du transistor MOS complémentaire, pendant la formation des zones (17) de source/drain du transistor MOS mentionné en premier, d'un masque (10) que l'on élimine ensuite à nouveau,
- dans lequel on recouvre la région du transistor MOSmentionné en premier d'un autre masque (15),
- dans lequel on élimine la couche de finition de l'électrode (6b) de grille du transistor MOS complémentaire,
- dans lequel on effectue une implantation par des ions dopés par le deuxième type de conductivité, dans lequel on forme les zones de source/drain du transistor (18) MOS complémentaire et dans lequel on augmente la concentration de la substance de dopage dans l'électrode (6b) de grille du transistor MOS complémentaire.
